(19) Europäisches Patentamt
European Patent Office
Office européen des brevets

(11) EP 4 147 845 A1

(12) **EUROPEAN PATENT APPLICATION**
published in accordance with Art. 153(4) EPC

(43) Date of publication:
**15.03.2023 Bulletin 2023/11**

(21) Application number: **21804541.7**

(22) Date of filing: **13.05.2021**

(51) International Patent Classification (IPC):
***B29C 39/10*** (2006.01) ***B32B 18/00*** (2006.01)
***H01L 23/14*** (2006.01) ***C04B 38/00*** (2006.01)
***C04B 41/83*** (2006.01) ***C04B 35/5835*** (2006.01)

(52) Cooperative Patent Classification (CPC):
**B29C 39/10; B32B 18/00; C04B 35/583; C04B 38/00; C04B 41/83; H01L 23/14**

(86) International application number:
**PCT/JP2021/018244**

(87) International publication number:
**WO 2021/230323 (18.11.2021 Gazette 2021/46)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **15.05.2020 JP 2020085841**

(71) Applicant: **Denka Company Limited**
**Tokyo 103-8338 (JP)**

(72) Inventors:
- **SUZUKI, Nobuya**
  **Tokyo 103-8338 (JP)**
- **INOUE, Saori**
  **Tokyo 103-8338 (JP)**
- **UESHIMA, Yasuhisa**
  **Tokyo 103-8338 (JP)**
- **YOSHIMATSU, Ryo**
  **Tokyo 103-8338 (JP)**
- **KOGA, Ryuji**
  **Tokyo 103-8338 (JP)**

(74) Representative: **Hoffmann Eitle**
**Patent- und Rechtsanwälte PartmbB**
**Arabellastraße 30**
**81925 München (DE)**

# (54) COMPOSITE AND PRODUCTION METHOD FOR COMPOSITE

(57) One aspect of the present disclosure provides a production method for a composite, the method including: a cooling step of performing cooling under a pressurized condition in a state where a heated molten material of a thermosetting composition is brought into contact with a resin-impregnated body, in which the above-described resin-impregnated body includes a nitride sintered body having a porous structure and a semi-cured product of the thermosetting composition impregnated into the above-described nitride sintered body.



Processed by Luminess, 75001 PARIS (FR)

## Description

### Technical Field

The present disclosure relates to a composite and a production method for a composite.

### Background Art

Electronic components such as LED lighting devices and in-vehicle power modules face the problem of efficiently dissipating heat generated when in use. To address this problem, measures such as a method for increasing the thermal conductivity of an insulating layer of a printed wiring board on which electronic components are mounted and a method for attaching electronic components or a printed wiring board to a heat sink via electrically insulating thermal interface materials are taken. A composite (heat dissipation member) composed of a resin and a ceramic such as boron nitride is used for such an insulating layer and thermal interface material.

As such a composite, one obtained by dispersing a ceramic powder in a resin is conventionally used. In recent years, a composite in which a porous ceramic sintered body (for example, a boron nitride sintered body) is impregnated with a resin has also been examined (for example, Patent Literature 1).

### Citation List

### Patent Literature

[Patent Literature 1] PCT International Publication No. WO2014/196496

### Summary of Invention

### Technical Problem

In a composite, it is beneficial to impregnate a sufficient amount of resin into pores of ceramics to improve the properties of the composite. For this reason, a step of impregnating ceramics with a resin or a composition containing a monomer that provides a resin is performed under pressurized conditions, and the pressure is controlled to improve the rate of resin impregnation into pores. However, according to the studies of the present inventors, even in a case where the pressure is adjusted as described above, a composite produced may not reach a desired resin impregnation rate, and it may be difficult to obtain a composite containing a high proportion of a semi-cured product with respect to the volume of pores.

An object of the present disclosure is to provide a production method for a composite in which the content of a semi-cured product in pores of a nitride sintered body may be increased.

### Solution to Problem

One aspect of the present disclosure provides a production method for a composite, the method including: a cooling step of performing cooling under a pressurized condition in a state where a heated molten material of a thermosetting composition is brought into contact with a resin-impregnated body, in which the above-described resin-impregnated body includes a nitride sintered body having a porous structure and a semi-cured product of the thermosetting composition impregnated into the above-described nitride sintered body.

In the above-described production method for a composite, the content of the semi-cured product in the obtained composite may be increased by performing the cooling step under a pressurized condition.

Pressure adjustment during impregnation of a thermosetting composition into a nitride sintered body in the conventional production method for a composite is effective for improving the resin impregnation rate. On the other hand, according to the studies of the present inventors, the ratio of a semi-cured product to the total pore volume of the nitride sintered body may decrease due to shrinkage accompanying curing of the thermosetting composition (curing shrinkage) and shrinkage of the semi-cured product accompanying cooling (solidification shrinkage), which continue to progress in a cooling process after a thermosetting composition is semi-cured through heating. Moreover they have found that the decrease in the ratio of the semi-cured product to the total pore volume of the nitride sintered body which is caused by the curing shrinkage and the solidification shrinkage can be prevented by further supplying a thermosetting composition or a semi-cured product of the thermosetting composition from outside in accordance with the above-described shrinkage through application of pressure in the cooling process after the thermosetting composition is semi-cured. The present inventors have reached the production method for a composite of the present disclosure based on these findings. Since

the production method for a composite of the present disclosure uses the above-described findings, a composite with a high content of a semi-cured product can also be prepared by additionally introducing the semi-cured product of a thermosetting composition into a composite with a low content of the semi-cured product produced through a conventional method.

In the above-described production method for a composite, the pressure in the above-described cooling step may be 2.0 MPa or higher.

The production method for a composite may further include: a preparation step of preparing the resin-impregnated body in which the above-described resin-impregnated body is obtained by heating and semi-curing the above-described thermosetting composition in a state where the nitride sintered body having a porous structure is brought into contact with the heated molten material of the thermosetting composition.

The above-described preparation step may include placing the above-described nitride sintered body and the heated molten material of the above-described thermosetting composition under a pressurized condition in a state where these are brought into contact with each other. A more sufficient amount of the thermosetting composition may be impregnated into pores of the nitride sintered body by pressurizing the nitride sintered body and the heated molten material of the thermosetting composition in a state where these are brought into contact with each other. In addition, the properties (for example, insulation properties) of a composite obtained may be further improved.

In the production method for a composite, the pressure in the above-described cooling step may be higher than that in the above-described preparation step. If the pressure in the cooling step is higher than that in the preparation step, a more sufficient amount of the thermosetting composition may be impregnated into pores of the nitride sintered body and the decrease in impregnation rate may be sufficiently prevented even in a case where the viscosity increases due to progression of curing of the thermosetting composition.

One aspect of the present disclosure provides a composite including: a nitride sintered body having a porous structure; and a semi-cured product of a thermosetting composition impregnated into the above-described nitride sintered body, in which a ratio of the above-described semi-cured product to a total pore volume of the above-described nitride sintered body is 99.0 volume% or higher.

The above-described composite contains a sufficient amount of the semi-cured product since the ratio of the above-described semi-cured product to the total pore volume of the above-described nitride sintered body is 99 volume% or higher.

## Advantageous Effects of Invention

According to the production method for a composite of the present disclosure, it is possible to produce a composite in which the content of a semi-cured product in pores of a nitride sintered body is increased. According to the present disclosure, it is also possible to provide a composite having a very high proportion of a semi-cured product.

## Description of Embodiments

Hereinafter, embodiments of the present disclosure will be described. However, the following embodiments are merely examples for describing the present disclosure and are not intended to limit the present disclosure to the following contents.

The materials exemplified in present specification can be used singly or in combination of two or more thereof unless otherwise specified. The content of each component in a composition means a total amount of multiple substances present in the composition unless otherwise specified in a case where there are multiple substances corresponding to the components in the composition. "Steps" in the present specification may be steps independent of each other or steps performed simultaneously.

The present disclosure relates to a production method for a composite including: a nitride sintered body having a porous structure; and a semi-cured product of the thermosetting composition impregnated into the above-described nitride sintered body. One embodiment of the production method for a composite includes: a cooling step of performing cooling under a pressurized condition in a state where a heated molten material of a thermosetting composition is brought into contact with a resin-impregnated body. The above-described resin-impregnated body includes: a nitride sintered body having a porous structure; and a semi-cured product of the thermosetting composition impregnated into the above-described nitride sintered body. The resin-impregnated body may be a composite obtained through a conventional production method, and the content of the semi-cured product may be, for example, 98 volume% or less or 80 volume% or less. The content of the above-described semi-cured product means a ratio of the semi-cured product to the total pore volume of the nitride sintered body.

The production method for a composite may further include: a step of preparing the resin-impregnated body in which the above-described resin-impregnated body is obtained by heating and semi-curing the above-described thermosetting composition in a state where the nitride sintered body having a porous structure is brought into contact

with (for example, immersed in) the heated molten material of the thermosetting composition. Hereinafter, the above-described preparation step is also referred to as a first step, and the above-described cooling step in which the above-described resin-impregnated body is cooled under a pressurized condition to obtain a composite is also referred to as a second step.

The nitride sintered body having a porous structure may be obtained by sintering primary particles of nitride. The nitride sintered body having a porous structure may be, for example, one (boron nitride sintered body) obtained by sintering primary particles of boron nitride. A "porous structure" in the present specification means a structure having a plurality of fine pores (hereinafter also referred to as pores) and includes a structure in which at least some pores described above are connected to each other to form continuous pores.

The upper limit value of the average pore diameter of the above-described pores may be, for example, 7 μm or less, 6 μm or less, or 5 μm or less. If the upper limit value of the average pore diameter is within the above-described ranges, thermal conductivity of a composite may be improved. The lower limit value of the average pore diameter of the above-described pores may be, for example, 0.3 μm or more, 0.5 μm or more, or 0.7 μm or more. If the lower limit value of the average pore diameter is within the above-described ranges, a thermosetting composition can be easily impregnated into the pores and adhesiveness of a composite with respect to an adherend may be further improved. The average pore diameter of the above-described pores may be adjusted to within the above-described ranges, and may be, for example, 0.3 to 7 μm, 0.5 to 6 μm, or 0.7 to 5 μm.

The "average pore diameter" in the present specification means a pore diameter at which the cumulative pore volume reaches 50% of the total pore volume in a pore diameter distribution (horizontal axis: pore diameter, longitudinal axis: cumulative pore volume) measured using a mercury porosimeter. As the mercury porosimeter, for example, a mercury porosimeter manufactured by Shimadzu Corporation can be used. The measurement range is set to 0.03 to 4,000 atm, and the measurement is performed while gradually increasing the pressure.

The total pore volume of a nitride sintered body may be adjusted according to the use or the like of a composite. The total pore volume of a nitride sintered body can be calculated as a value obtained by multiplying the volume of the nitride sintered body by the porosity of the nitride sintered body to be described below.

The lower limit value of the proportion of the pores (porosity) in the nitride sintered body may be, for example, 10 volume% or more, 30 volume% or more, or 50 volume% or more based on the total volume of the nitride sintered body. When the lower limit value of the proportion of the pores in the nitride sintered body is within the above-described ranges, the content of a semi-cured product may be improved and a sufficient mechanical strength may be secured. The upper limit value of the proportion of the pores in the nitride sintered body may be, for example, 70 volume% or less, 60 volume% or less, or 55 volume% or less based on the total volume of the nitride sintered body. When the upper limit value of the proportion of the pores in the nitride sintered body is within the above-described ranges, both insulation properties and thermal conductivity of a composite may be achieved at a higher level. The proportion of the pores (porosity) in the nitride sintered body may be adjusted to within the above-described ranges, and may be, for example, 10 to 70 volume%, 30 to 60 volume%, or 50 to 55 volume%.

The proportion of the pores (porosity) in the nitride sintered body in the present specification means a value calculated using a bulk density D (unit: g/cm$^3$) obtained from the volume and mass of the nitride sintered body and a theoretical density $D_0$ of a nitride (in a case where the nitride is boron nitride, $D_0$ is 2.28 g/cm$^3$) based on Equation (I) below. In a case where a composite is a measurement target, it can be measured by burning and removing a semi-cured product.

$$\text{Porosity} = [1-(D/D_0)]\times 100 \qquad \text{(I)}$$

The nitride sintered body may be obtained by molding nitride powder and then sintering the molded nitride powder, or may be prepared by an own method. That is, the above-described production method for a composite may further include: a step of molding powder containing a nitride to obtain a molded body of the nitride; and a step of sintering the molded body of the nitride to obtain a nitride sintered body. The molding step may be a step, for example, of spheroidizing a slurry containing nitride powder with a spray dryer or the like and molding the obtained spherical nitride granules through press molding and a cold isostatic pressing (CIP) to obtain a molded body. The pressure during molding in the molding step is not particularly limited. However, there is a tendency that the higher the pressure, the smaller the average pore diameter of the obtained nitride sintered body, and the lower the pressure, the larger the average pore diameter of the obtained nitride sintered body.

The nitride may include, for example, at least one selected from the group consisting of boron nitride, aluminum nitride, and silicon nitride, and preferably includes boron nitride. Both amorphous boron nitride and hexagonal boron nitride can be used as boron nitride. The thermal conductivity of a nitride may be, for example, 20 W/(m·K) or more, 50 W/(m·K) or more, or 60 W/(m·K). The heat resistance of a composite obtained may be further reduced if a nitride having excellent thermal conductivity as described above is used as a nitride.

The powder containing a nitride may further contain a sintering aid and the like in addition to the nitride. The sintering aid may be, for example, rare earth element oxides such as yttria oxide, alumina oxide, and magnesium oxide, alkali metal carbonates such as lithium carbonate and sodium carbonate, and boric acid. The content of the sintering aid may be, for example, 0.5 to 25 parts by mass, 0.5 to 20 parts by mass, 0.5 to 15 parts by mass, 0.5 to 10 parts by mass, or 0.5 to 5 parts by mass based on 100 parts by mass of the nitride powder. By setting the content of the sintering aid to be within the above-described ranges, the average pore diameter of the nitride sintered body may be easily adjusted.

The lower limit value of the sintering temperature in the sintering step may be, for example, 1600°C or higher or 1700°C or higher. The upper limit value of the sintering temperature in the sintering step may be, for example, 2200°C or lower or 2000°C or lower. The sintering temperature in the sintering step may be adjusted to within the above-described ranges, and may be, for example, 1600°C to 2200°C or 1700°C to 2000°C. The sintering time may be, for example, 1 to 30 hours. The atmosphere during sintering may be, for example, an inert gas atmosphere such as nitrogen, helium, and argon.

A batch type furnace and a continuous type furnace can be used for sintering. Examples of batch type furnaces include a muffle furnace, a tubular furnace, and an atmospheric furnace. Examples of continuous type furnaces include a rotary kiln, a screw conveyor furnace, a tunnel furnace, a belt furnace, a pusher furnace, and a koto-shaped continuous furnace.

A thermosetting composition used in the above-described production method for a composite may contain, for example, at least one compound selected from the group consisting of a compound having a cyanate group, a compound having a bismaleimide group, and a compound having an epoxy group, and at least one curing agent selected from the group consisting of a phosphine-based curing agent and an imidazole-based curing agent. When the thermosetting composition has the above-described composition, the viscosity of the thermosetting composition during impregnation may be reduced and the curing time when a composite is adhered to an adherend may be shortened.

Examples of compounds having a cyanate group include dimethylmethylenebis(1,4-phenylene)biscyanate and bis(4-cyanatophenyl)methane.

Dimethylmethylenebis(1,4-phenylene)biscyanate is commercially available, for example, as TACN (manufactured Mitsubishi Gas Chemical Company, Inc., trade name).

Examples of compounds having bismaleimide group include N,N'-[(1-methylethylidene)bis[(p-phenylene)oxy(p-phenylene)]]bismal eimide and 4,4'-diphenylmethane bismaleimide. N,N'-[(1-methylethylidene)bis[(p-phenylene)oxy(p-phenylene)]]bismal eimide is commercially available as, for example, BMI-80 (manufactured by K·I Chemical Industry Co., Ltd., trade name).

Examples of compounds having an epoxy group include 1,6-bis(2,3-epoxypropan-1-yloxy)naphthalene and compounds represented by General Formula (1) below. In General Formula (1), the value of N is not particularly limited, but may be an integer of 0 or more, usually 1 to 10 and preferably 2 to 5. 1,6-bis(2,3-epoxypropan-1-yloxy)naphthalene is commercially available as, for example, HP-4032D (manufactured by DIC Corporation, trade name).

[Chem. 1]

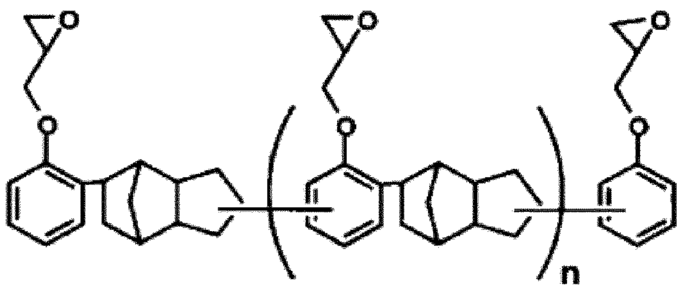

(1)

The total amount of the compound having a cyanate group, the compound having a bismaleimide group, and the compound having an epoxy group in the thermosetting composition may be 50 mass% or more, 70 mass% or more, 80 mass% or more, or 90 mass% or more based on the total amount of the thermosetting composition.

The content of the compound having a cyanate group in the thermosetting composition may be, for example, 50 parts by mass or more, 60 parts by mass or more, or 70 parts by mass or more based on 100 parts by mass of the total amount of the compound having a cyanate group and the compound having a bismaleimide group. If the content of the compound having a cyanate group in the thermosetting composition is within the above-described ranges, the curing reaction can proceed rapidly when a composite obtained is adhered to an adherend, and the dielectric breakdown voltage of the composite after the adhesion to the adherend may be improved. In a case where the adhesion conditions

to the adherend is set to the adhesion conditions in the examples, the effect of improving the dielectric breakdown voltage may be made more significant.

The content of the compound having a bismaleimide group in the thermosetting composition may be, for example, 15 parts by mass or more, 20 parts by mass or more, or 25 parts by mass or more based on 100 parts by mass of the total amount of the compound having a cyanate group and the compound having a bismaleimide group. If the content of the compound having a bismaleimide group in the thermosetting composition is within the above-described ranges, the water absorption rate of a semi-cured product may be lowered, and the reliability of a product may be improved.

The content of the compound having an epoxy group in the thermosetting composition may be, for example, 10 parts by mass or more, 20 parts by mass or more, or 30 parts by mass or more based on 100 parts by mass of the total amount of the compound having a cyanate group and the compound having a bismaleimide group. The content of the compound having an epoxy group in the thermosetting composition may be, for example, 70 parts by mass or less or 60 parts by mass or less based on 100 parts by mass of the total amount of the compound having a cyanate group and the compound having a bismaleimide group. If the content of the compound having an epoxy group in the thermosetting composition is within the above-described ranges, a decrease in the temperature at which thermosetting of the thermosetting composition starts may be suppressed, and the thermosetting composition is more easily impregnated into the nitride sintered body. The content of the compound having an epoxy group in the thermosetting composition may be adjusted to within the above-described ranges, and may be, for example, 10 to 70 parts by mass or 30 to 60 parts by mass based on 100 parts by mass of the total amount of the compound having a cyanate group and the compound having a bismaleimide group.

The above-described curing agent may contain a phosphine-based curing agent and an imidazole-based curing agent.

Phosphine-based curing agents can promote a triazine formation reaction due to trimerization of a cyanate resin or a compound having a cyanate group. Examples of phosphine-based curing agents include tetraphenylphosphonium tetra-p-tolylborate and tetraphenylphosphonium tetraphenylborate. Tetraphenylphosphonium tetra-p-tolylborate is commercially available as, for example, TPP-MK (manufactured by Hokko Chemical Industry Co., Ltd., trade name).

Imidazole-based curing agents produce oxazoline and promote a curing reaction of an epoxy resin or a compound having an epoxy group. Examples of imidazole-based curing agents include 1-(1-cyanomethyl)-2-ethyl-4-methyl-1H-imidazole and 2-ethyl-4-methylimidazole. 1-(1-cyanomethyl)-2-ethyl-4-methyl-1H-imidazole is commercially available, for example, as 2E4MZ-CN (manufactured by Shikoku Chemicals Corporation, trade name).

The content of a phosphine-based curing agent may be, for example, 5 parts by mass or less, 4 parts by mass or less, or 3 parts by mass or less based on 100 parts by mass of the total amount of the compound having a cyanate group, the compound having a bismaleimide group, and the compound having an epoxy group. The content of the phosphine-based curing agent may be, for example, 0.1 parts by mass or more or 0.5 parts by mass or more based on 100 parts by mass of the total amount of the compound having a cyanate group, the compound having a bismaleimide group, and the compound having an epoxy group. If the content of the phosphine-based curing agent is within the above-described ranges, a composite may be easily produced and the time required for adhesion of the composite to an adherend may be further shortened. The content of the phosphine-based curing agent may be adjusted to within the above-described ranges, and may be, for example, 0.1 to 5 parts by mass or 0.5 to 3 parts by mass based on 100 parts by mass of the total amount of the compound having a cyanate group, the compound having a bismaleimide group, and the compound having an epoxy group.

The content of an imidazole-based curing agent may be, for example, 0.1 parts by mass or less, 0.05 parts by mass or less, or 0.03 parts by mass or less based on 100 parts by mass of the total amount of the compound having a cyanate group, the compound having a bismaleimide group, and the compound having an epoxy group. The content of the imidazole-based curing agent may be, for example, 0.001 parts by mass or more or 0.005 parts by mass or more based on 100 parts by mass of the total amount of the compound having a cyanate group, the compound having a bismaleimide group, and the compound having an epoxy group. If the content of the imidazole-based curing agent is within the above-described ranges, a composite may be easily produced and the time required for adhesion of the composite to an adherend may be further shortened. The content of the imidazole-based curing agent may be adjusted to within the above-described ranges, and may be, for example, 0.001 to 0.1 parts by mass or 0.005 to 0.03 parts by mass based on 100 parts by mass of the total amount of the compound having a cyanate group, the compound having a bismaleimide group, and the compound having an epoxy group.

The thermosetting composition may contain other components in addition to the compound having a cyanate group, the compound having a bismaleimide group, the compound having an epoxy group, and the curing agent. The other components may include, for example, other resins such as a phenolic resin, a melamine resin, an urea resin, and an alkyd resin, a silane coupling agent, a leveling agent, an anti-foaming agent, a surface conditioner, and a wetting dispersant. The content of the other components may be, for example, 20 mass% or less, 10 mass% or less, or 5 mass% or less based on the total amount of the thermosetting composition.

The viscosity of the above-described thermosetting composition can be appropriately adjusted. The upper limit

value of the viscosity of the thermosetting composition at 100°C may be, for example, 50 mPa·sec or less, 30 mPa·sec or less, 20 mPa·sec or less, 10 mPa·sec or less, or 5 mPa·sec or less. If the viscosity of the above-described thermosetting composition at 150°C is within the above-described ranges, a composite is more easily prepared. The lower limit value of the viscosity of the above-described thermosetting composition at 100°C may be, for example, 3 mPa·sec or more. The viscosity of the above-described thermosetting composition at 100°C is preferably maintained, for example, at 50 mPa·sec or less for 5 hours or longer in a state in which the temperature of the thermosetting composition is maintained at 100°C. The viscosity of the thermosetting composition at 100°C may be adjusted to within the above-described ranges, and may be, for example, 3 to 50 mPa·sec or 3 to 5 mPa·sec.

The viscosity of the above-described thermosetting composition at 100°C means a value measured using a rotary type viscometer under the condition of a shear rate of 10 (1/sec). The viscosity of the thermosetting composition may be adjusted by adding a solvent, for example. That is, a target in which a nitride sintered body is to be immersed may be set to a heated molten material of a mixture containing a thermosetting composition and a solvent instead of a heated molten material of a thermosetting composition. In this case, the viscosity of the above-described mixture may be adjusted so as to be the above-described viscosity of the above-described thermosetting composition. Examples of the above-described solvents include toluene, ethylene glycol, and dimethyl sulfoxide (DMSO).

In the first step (the preparation step of a resin-impregnated body), the above-described nitride sintered body is brought into contact with (for example, immersed in) a heated molten material of the above-described thermosetting composition using an impregnation device or the like, and the thermosetting composition is impregnated into pores of the above-described nitride sintered body.

The thermosetting composition or the mixture containing the thermosetting composition may be heated in the first step. The heating temperature at this time may be, for example, higher than the heating temperature for semi-curing the thermosetting composition. The upper limit of the above-described heating temperature may be, for example, +20°C or less than the heating temperature for semi-curing the thermosetting composition. By setting the above-described heating temperature to be within the above-described ranges, the viscosity of the heated molten material is adjusted, the impregnation of the thermosetting composition is more easily performed, and a composite with a higher content of a semi-cured product is obtained. The heating temperature for semi-curing the thermosetting composition means a temperature at which the reaction of the thermosetting composition starts, and is specifically a curing temperature (which is the lowest curing temperature among curing temperatures in a case where a plurality of curing agents are contained) corresponding to each curing agent.

In the first step, the nitride sintered body may be kept in contact with the heated molten material of the thermosetting composition or the mixture containing the thermosetting composition for a predetermined time before heating starts. The holding time in the contact state (for example, immersed state) may be, for example, 5 hours or more, 10 hours or more, 100 hours or more, or 150 hours or more. By holding the nitride sintered body in the contact state, a more sufficient amount of the thermosetting composition may be impregnated into pores of the nitride sintered body.

The above-described impregnation may be performed under atmospheric pressure, or may be performed under either a reduced pressure condition or a pressurized condition. A combination of impregnation under a reduced pressure condition and impregnation under a pressurized condition may be performed. That is, the above-described first step may include placing the above-described nitride sintered body and the heated molten material of the above-described thermosetting composition under a reduced pressure condition and/or a pressurized condition in a state where these are brought into contact with each other. Here, in a case where a reduced pressure condition is included, gas components dissolved in the nitride sintered body and the thermosetting composition may be deaerated, and the content of a semi-cured product of the thermosetting composition in a composite can be more increased.

In a case where the thermosetting composition is impregnated under a reduced pressure condition, the pressure in an impregnation device may be, for example, 1000 MPa or lower, 500 MPa or lower, 100 MPa or lower, 50 MPa or lower, or 20 MPa or lower. In a case where the thermosetting composition is impregnated under a pressurized condition, the pressure in an impregnation device may be, for example, 0.5 MPa or higher, 3 MPa or higher, 10 MPa or higher, or 30 MPa or higher. The pressure in an impregnation device in the case where the thermosetting composition is impregnated under a reduced pressure condition may be adjusted to within the above-described ranges, and may be, for example, 0.5 to 1000 MPa, 3 to 500 MPa, 10 to 100 MPa, or 30 to 50 MPa.

In the first step, a resin-impregnated body is prepared by semi-curing a thermosetting composition through heat treatment performed in a state in which the thermosetting composition is impregnated into pores of a nitride sintered body. The semi-cured state of the thermosetting composition in a composite can be adjusted according to the conditions of the above-described heat treatment. The heating temperature in the first step can be adjusted depending on the components, composition, and the like of the thermosetting composition, and may be, for example, 80°C to 130°C.

The above-described heat treatment in the first step may be performed under atmospheric pressure or a pressurized condition.

The "semi-cured" state (also referred to as a B-stage) in the present specification means that the thermosetting composition may be in a state in which it can be further cured through a subsequent curing treatment. Utilizing the semi-cured state, a composite can also be temporarily press-bonded to an adherend such as a metal substrate and then heated to be adhered to the adherend. The above-described semi-cured product is in a semi-cured state and can be further cured to enter a "completely cured" state (also referred to as a C-stage). Whether or not a semi-cured product in a composite is in a semi-cured state in which it can be further cured can be confirmed, for example, using a differential scanning calorimeter.

A semi-cured product of a thermosetting composition (hereinafter sometimes simply referred to as a "semi-cured product") means a product in which a curing reaction of the thermosetting composition has proceeded to a certain extent or more. Accordingly, the semi-cured product of the thermosetting composition may contain a thermosetting resin or the like obtained by reacting raw material components in the thermosetting composition (such as compounds contained in the thermosetting composition). The above-described semi-cured product may contain unreacted compounds or the like among the above-described raw material components in addition to the above-described thermosetting resin.

The curing rate of a thermosetting composition when the curing rate thereof in a completely cured state is taken as 100% may be used as an index of the degree of curing of a semi-cured product, for example. The curing rate of a semi-cured product may be, for example, 70% or less, 65% or less, or 60% or less. If the curing rate of a semi-cured product is within the above-described ranges, the adhesiveness of a composite with respect to an adherend may be improved. In addition, voids in a resin composite may be filled with a semi-cured product due to a movement of the semi-cured product in the resin composite, thereby improving the dielectric breakdown voltage. In addition, the curing rate of a semi-cured product may be, for example, 5% or more, 15% or more, 30% or more, or 40% or more. If the curing rate of a semi-cured product is within the above-described ranges, the semi-cured product may be suppressed from flowing out of a resin composite and a sufficient amount of the semi-cured product may be held in pores of a nitride sintered body. The curing rate of a semi-cured product may be adjusted to within the above-described ranges, and may be, for example, 5% to 70%, 30% to 65%, or 40% to 60%.

The above-described curing rate can be determined by measurement using a differential scanning calorimeter. First, the amount of heat Q generated when 1 g of an uncured thermosetting composition is completely cured is measured. Next, 1 g of a semi-cured product is collected from a composite to be measured, and the amount of heat R generated when the collected semi-cured product is completely cured is measured. A differential scanning calorimeter is used for measurement. Thereafter, the curing rate of the semi-cured product can be calculated according to Equation (A) below. Whether or not the semi-cured product is completely cured can be confirmed by the end of heat generation in a heat generation curve obtained through differential scanning calorimetry.

$$\text{Curing rate [\%] of semi-cured product} = [(Q-R)/R]\times 100 \quad (A)$$

The above-described curing rate may be calculated as follows. That is, the curing rate of a semi-cured product impregnated into a nitride sintered body can be obtained through the following method. First, a heat generation amount Q2 generated when the temperature of an uncured thermosetting composition is raised to completely cure the uncured thermosetting composition is obtained. Then, a heat generation amount R2 generated when the temperature of a sample collected from a semi-cured product in a composite is raised in the same manner to completely cure the sample is obtained. At this time, the mass of the sample used for measurement using a differential scanning calorimeter is the same as that of the thermosetting composition used for measuring the heat generation amount Q2. In a case where the mass of the sample used for measurement is insufficient, values obtained by converting the above-described heat generation amount Q2 and the above-described heat generation amount R2 into heat generation amounts per unit mass may be used. Assuming that c (mass%) of a thermosetting component is contained in a semi-cured product, the curing rate of a thermosetting composition impregnated into a composite is obtained by Equation (B) below.

$$\text{Curing rate [\%] of semi-cured product impregnated} = \{1-[(R2/c)\times 100]/Q2\}\times 100 \quad (B)$$

A resin-impregnated body obtained through a heat treatment has a semi-cured product of a thermosetting composition. The semi-cured product may contain at least one thermosetting resin selected from the group consisting of a cyanate resin, a bismaleimide resin, and an epoxy resin, and a curing agent. The semi-cured product may contain, in addition to the above-described thermosetting resins and curing agent, for example, other resins such as a phenolic resin, a melamine resin, an urea resin, and an alkyd resin, and components derived from a silane coupling agent, a leveling agent, an anti-foaming agent, a surface conditioner, a wetting dispersant, and the like. The total content of the other resins and the components may be, for example, 20 mass% or less, 10 mass% or less, or 5 mass% or less based on the total amount of the semi-cured product.

The second step (cooling step) is a step of obtaining a composite by cooling, under a pressurized condition, the above-described resin-impregnated body which is in a heated state to semi-cure a thermosetting composition. That is, the second step may be a step of performing cooling under a pressurized condition after semi-curing a thermosetting composition in a state in which a heated molten material of the above-described thermosetting composition is brought into contact with a resin-impregnated body.

In the second step, even if curing shrinkage of a thermosetting composition and solidification shrinkage of a semi-cured product occur due to cooling under a pressurized condition, a thermosetting composition or a semi-cured product of a thermosetting composition is supplied from the surroundings, and the content of the semi-cured product with respect to pores in an obtained composite may be made significantly high. For example, in a case of targeting a resin-impregnated body prepared in advance, the above-described resin-impregnated body is subjected to a cooling step (second step) while being brought into contact with a heated molten material of a thermosetting composition to supply the melted thermosetting composition from the periphery of the resin-impregnated body to an unimpregnated portion of the resin-impregnated body. Furthermore, since the semi-cured product in the resin-impregnated body prepared in advance can also be melted by receiving heat supplied from the surroundings, it is possible to reduce the proportion of voids or the like that were initially formed and to further improve the impregnation rate. At this time, a thermosetting composition constituting a semi-cured product contained in a resin-impregnated body may be the same as or different from a thermosetting composition constituting a heated molten material to be brought into contact with the above-described resin-impregnated body. By the action as described above, it is possible to produce a composite with an increased content of a semi-cured product. Specifically, in the cooling step, cooling may be performed under pressure, for example, by immersing a resin-impregnated body in a thermosetting composition contained in a container. The viscosity of the thermosetting composition at 120°C may be, for example, 1000 to 3000000 mPa·sec or 1000 to 300000 mPa·sec.The viscosity of the above-described thermosetting composition at 120°C means a value measured using a rotary type viscometer under the condition of a shear rate of 10 (1/sec).

The pressure in the second step (cooling step) may be higher than that in the above-described first step (preparation step). If the pressure in the second step is higher than that in the first step, a more sufficient amount of the thermosetting composition may be impregnated into pores of the nitride sintered body even in the cooling process and the decrease in impregnation rate may be sufficiently prevented even in a case where the viscosity increases due to progression of curing of the thermosetting composition.

The pressure of the second step can be adjusted according to the composition, the viscosity, and the like of a semi-cured product. The lower limit value of the pressure in the above-described second step may be, for example, 2.0 MPa or more, 3.0 MPa or more, 4.0 MPa or more, 10 MPa or more, 15 MPa or more, or 30 MPa or more. By setting the lower limit value of the above-described pressure to be within the above-described ranges, a more sufficient amount of a thermosetting composition may be impregnated so as to compensate for the decrease in the content of a semi-cured product due to shrinkage thereof. The upper limit value of the pressure in the second step is not particularly limited, but may be, for example, 1000 MPa or less, 500 MPa or less, 100 MPa or less, 50 MPa or less, or 20 MPa or less. The pressure in the second step may be adjusted to within the above-described ranges, and may be, for example, 2.0 to 1000 MPa, 2.0 to 100 MPa, 2.0 to 20 MPa, or 3.0 to 20 MPa.

The above-described resin-impregnated body in the second step may be, for example, cooled to room temperature. The upper limit value of the temperature decrease rate in the second step may be, for example, 15°C/min or lower, 5°C/min or lower, 3°C/min or lower, or 2°C/min or lower. By setting the temperature decrease rate in the second step to be within the above-described ranges, heating history accompanying cooling of a thermosetting resin can be reduced and the resin portion can be sufficiently maintained even after a composite is connected to an adherend. Therefore, the insulation performance of the connected body may be further improved. The lower limit value of the temperature decrease rate in the second step is not particularly limited, but may be, for example, 0.2°C/min or higher or 0.5°C/min or higher. The temperature decrease rate in the second step may be adjusted to within the above-described ranges, and may be, for example, 0.2°C/min to 15°C/min or 0.5°C/min to 10°C/min.

The above-described production method for a composite may include other steps in addition to the first step and the second step. Examples of the other steps include a step of cutting an obtained composite into a desired size. In the above-described production method for a composite, since a thermosetting composition is cured in a state in which a nitride sintered body is immersed in a container filled with the thermosetting composition, a layer containing a semi-cured product of the thermosetting composition can be formed around the nitride sintered body in a composite obtained. Therefore, the layer containing the surrounding semi-cured product may be cut and removed, or the composite may be cut into a predetermined thickness to prepare a composite sheet. A nitride sintered body adjusted to a desired thickness in advance may be used instead of cutting the produced composite and forming it into a sheet shape. That is, in the above-described production method, a composite sheet may be produced by impregnating a thermosetting composition into a sheet-like nitride sintered body.

In the case of producing a composite sheet, the upper limit value of the thickness of the composite sheet may be, for example, 1.00 mm or less, 0.90 mm or less, 0.80 mm or less, 0.70 mm or less, 0.50 mm or less, or 0.40 mm or

less. If the upper limit value of the thickness of the composite sheet is within the above-described ranges, heat resistance of the composite sheet itself may be further reduced. The lower limit value of the thickness of the above-described composite sheet may be, for example, 0.15 mm or more or 0.20 mm or more. If the lower limit value of the thickness of the composite sheet is within the above-described ranges, more sufficient insulation properties may be exhibited even in a case where a layered body obtained using the above-described composite sheet is used at a high voltage. The thickness of the composite sheet may be adjusted to within the above-described ranges, and may be, for example, 0.15 to 1.0 mm or 0.20 to 0.50 mm.

According to the above-described production method for a composite, it is possible to produce a composite having a high proportion of a semi-cured product. As a composite, it is possible to provide, for example, a composite including: a nitride sintered body having a porous structure; and a semi-cured product of a thermosetting composition impregnated into the above-described nitride sintered body, in which a ratio of the above-described semi-cured product to a total pore volume of the above-described nitride sintered body is 80 volume% or higher.

The ratio of the above-described semi-cured product to the total pore volume of the above-described nitride sintered body can be set to, for example, 99.0 volume% or higher or 99.5 volume% or higher. In particular, a composite having a significantly high content of a semi-cured product can be produced by performing at least one adjustment of the pressure in the second step so as to be sufficiently high or the temperature decrease rate during cooling so as to be sufficiently low. Specifically, the content of a semi-cured product in a composite can be set to, for example, 99.0 volume% or more or 99.5 volume% or more. The sufficiently high pressure varies depending on the viscosity or the like of a thermosetting composition to be used, and may be 2.0 MPa or higher or 3.0 MPa or higher. The sufficiently low temperature decrease rate may be 15°C/min or lower, 10°C/min or lower, 8°C/min or lower, 5°C/min or lower, or 2°C/min or lower.

Specifically, the ratio of the above-described semi-cured product to the total pore volume of the above-described nitride sintered body means a value calculated based on Equation (II) below using a theoretical density $D_1$ (unit: g/cm$^3$) when all the pores of the nitride sintered body were impregnated with the above-described semi-cured product, a bulk density D (unit: g/cm$^3$) obtained from the volume and mass of the nitride sintered body, and a bulk density $D_2$ (unit: g/cm$^3$) obtained from the volume and mass of the above-described composite.

$$\text{Ratio of semi-cured product to total pore volume of nitride sintered body [volume\%]} = [(D_2-D)/(D_1-D)]\times 100 \qquad \text{(II)}$$

The theoretical density $D_1$ in Equation (II) above means a value obtained by the following equation.

$$\text{Theoretical density of composite} = \text{true density of boron nitride} + \text{true density of resin} \times (1 - \text{bulk density of boron nitride} / \text{true density of boron nitride})$$

The above-described composite has excellent dielectric breakdown voltage. The lower limit value of the dielectric breakdown voltage of the composite can be set to, for example, 4.5 kV or more, 5.0 kV or more, 6.0 kV or more, 7.0 kV or more, 8.0 kV or more, 9.0 kV or more, or 10.0 kV or more. The upper limit value of the dielectric breakdown voltage of the above-described composite may be, for example, 15 kV or less or 13 kV or less. The dielectric breakdown voltage of the above-described composite can be adjusted depending on, for example, the composition of a thermosetting composition or the content of a semi-cured product.

The "dielectric breakdown voltage" in the present specification means a value measured with a withstand voltage tester in compliance with JIS C2110-1:2016 for a measurement sample prepared such that conductive tape of the same size was attached to both surfaces of the above-described composite sheet at a position 2 mm away from the creepage surface of the composite sheet. As the withstand voltage tester, "TOS-8700" (device name) or the like manufactured by Kikusui Electronics Corp. can be used.

The above-described composite can be used as an adhesive member (for example, an adhesive sheet or the like) that requires thermal conductivity and insulation properties. The above-described composite may be specifically used as an adhesive member for adhering metal circuit boards to other layers in a power module structure, an LED light emitting device, and the like. That is, the above-described composite is suitable for producing a layered body.

One embodiment of a layered body includes: a first metal substrate; an intermediate layer provided on the first metal substrate; and a second metal substrate provided on a side of the above-described intermediate layer opposite

to the first metal substrate, in which the above-described first metal substrate and the above-described second metal substrate are connected to each other via the above-described intermediate layer. The above-described intermediate layer is a cured product of the above-described composite.

The thicknesses of the first metal substrate and the second metal substrate may be independently, for example, 0.035 mm or more and 10 mm or less. The first metal substrate and the second metal substrate may form, for example, a circuit.

The first metal substrate and the second metal substrate may be the same or different metal substrates. The first metal substrate and the second metal substrate may contain, for example, at least one selected from the group consisting of copper and aluminum, and may be copper or aluminum. The first metal substrate and the second metal substrate may contain metals other than copper and aluminum.

The above-described layered body can be produced through, for example, the following method. One embodiment of a production method for a layered body includes: a step of arranging and stacking a first metal substrate and a second metal substrate so as to face a pair of main surfaces of the above-described composite sheet, heating the structure in a state in which the above-described first metal substrate and the above-described second metal substrate are pressed in the stacking direction, and curing the above-described thermosetting composition to connect the above-described composite sheet to the above-described first metal substrate and the above-described second metal substrate.

Since the above-described composite is used in the above-described production method for a layered body, the first metal substrate and the second metal substrate may be adhered to each other in a short period of time. The adhesion time can be set to 2 hours or shorter, 1 hour or shorter, or 0.5 hours or shorter.

Some embodiments have been described above, but the present disclosure is not limited to any of the above-described embodiments. In addition, the contents of the description of the above-described embodiments can be applied to each other.

[Examples]

Hereinafter, the contents of the present disclosure will be described in more detail with reference to examples and comparative examples. However, the present disclosure is not limited to the following examples.

(Example 1)

[Preparation of nitride sintered body having porous structure]

40.0 mass% of amorphous boron nitride powder (manufactured by Denka Company Limited, oxygen content: 1.5%, boron nitride purity: 97.6%, average particle diameter: 6.0 μm) and 60.0 mass% of hexagonal boron nitride powder (manufactured by Denka Company Limited, oxygen content: 0.3%, boron nitride purity: 99.0%, average particle diameter: 30.0 μm) were weighed, sintering aids (boric acid and calcium carbonate) were added thereto, and then, an organic binder and water were added thereto and mixed together. Then, the mixture was dried and granulated to prepare a nitride powder mixture.

A mold was filled with the above-described powder mixture and press-molded under a pressure of 5 MPa to obtain a molded body. Next, the above-described molded body was compressed by applying a pressure of 20 to 100 MPa using a cold isostatic pressing (CIP) device (manufactured by Kobe Steel, Ltd., trade name: ADW800). The compressed molded body was sintered while holding the temperature at 2000°C for 10 hours using a batch-type high-frequency furnace (manufactured by Fuji Dempa Kogyo Co., Ltd., trade name: FTH-300-1H) to prepare a nitride sintered body. The porosity of the obtained nitride sintered body was 45 volume%. The calcination was performed by adjusting the inside of the furnace to a nitrogen atmosphere while allowing nitrogen to flow into the furnace at a standard flow rate of 10 L/minute.

[Preparation of thermosetting composition]

80 parts by mass of a compound having a cyanate group, 20 parts by mass of a compound having a bismaleimide group, and 50 parts by mass of a compound having an epoxy group were weighed into a container, 1 part by mass of a phosphine-based curing agent and 0.01 parts by mass of an imidazole-based curing agent were added to and mixed with 100 parts by mass of a total amount of the above-described three compounds. Since the epoxy resin was in a solid state at room temperature, it was mixed therewith while being heated to about 80°C. The viscosity of the obtained thermosetting composition at 100°C was 10 mPa·sec.

The following compounds were used for the preparation of the thermosetting composition.

<Compound having specific functional group>

Compound having cyanate group: dimethylmethylenebis(1,4-phenylene)biscyanate (manufactured by Mitsubishi Gas Chemical Company, Inc., trade name: TA-CN)
Compound having bismaleimide group: N,N'-[(1-methylethylidene)bis[(p-phenylene)oxy(p-phenylene)]]bismaleimide (manufactured by K·I Chemical Industry Co., Ltd., trade name: BMI-80)
Compound having epoxy group: 1,6-bis(2,3-epoxypropan-1-yloxy)naphthalene (manufactured by DIC Corporation, trade name: HP-4032D)
Compound having benzoxazine group: Bisphenol F-type benzoxazine (manufactured by Shikoku Chemicals Corporation, trade name: F-a-type benzoxazine)

<Curing agent>

Phosphine-based curing agent: tetraphenylphosphonium tetra-p-tolylborate (manufactured by Chemical Co., Ltd., trade name: TPP-MK)
Imidazole-based curing agent: 1-(1-cyanomethyl)-2-ethyl-4-methyl-1H-imidazole (manufactured by Shikoku Chemicals Corporation, trade name: 2E4MZ-CN)
Metal catalyst: bis(2,4-pentanedionato)zinc(II) (Tokyo Chemical Industry Co., Ltd.)

[Production of composite]

The nitride sintered body prepared as described above was impregnated with the thermosetting composition prepared as described above through the following method. First, the above-described nitride sintered body and the above-described thermosetting composition in the container were placed in a vacuum heating impregnation device (manufactured by Kyosin Engineering, trade name: G-555AT-R). Next, the device was deaerated for 10 minutes under the conditions of a temperature of 100°C and a pressure of 15 Pa. After the deaeration, the above-described nitride sintered body was immersed in the heated molten material of the above-described thermosetting composition for 40 minutes while maintaining the same conditions, and the thermosetting composition was impregnated (vacuum impregnated) into the above-described nitride sintered body.
Next, the container containing the above-described nitride sintered body and thermosetting composition was taken out, placed in a hot press impregnation device (manufactured by Kyosin Engineering, trade name: HP-4030AA-H45) as it was, and held for 120 minutes under the conditions of a temperature of 100°C and a pressure of 3.5 MPa to further impregnate (pressure-impregnate) the thermosetting composition into the nitride sintered body.
Thereafter, the container containing the nitride sintered body and the thermosetting composition was taken out of the device and subjected to a heat treatment as it was for 20 hours under the conditions of a temperature of 100°C and an atmospheric pressure of 0.10 MPa), and the thermosetting composition was semi-cured to obtain a resin-impregnated body.
After the heat treatment for 20 hours, the resin-impregnated body and the surrounding semi-cured product of the thermosetting composition were placed in the hot press impregnation device (manufactured by Kyosin Engineering, trade name: HP-4030AA-H45) while these were heated (before the system was cooled), and were cooled to room temperature (25°C) over 90 minutes under the condition of a pressure of 4.0 MPa to prepare a composite. After cutting and removing the layer of the semi-cured product provided around the composite, a composite sheet having a thickness of 0.4 mm was cut out.

(Example 2)

A composite was prepared in the same manner as in Example 1 except that a heat treatment for semi-curing was performed after vacuum impregnation without performing pressure impregnation and that the pressure condition and the temperature decrease rate in the cooling step were changed as shown in Table 1.

(Example 3)

A composite was prepared in the same manner as in Example 1 except that the pressure condition and the temperature decrease rate in the cooling step were changed as shown in Table 1.

(Comparative Example 1)

A composite was prepared in the same manner as in Example 1 except that cooling after a heat treatment for

8 hours was performed under atmospheric pressure rather than under a pressurized condition.

(Comparative Example 2)

A composite was prepared in the same manner as in Example 1 except that cooling after a heat treatment for 8 hours was performed under atmospheric pressure rather than under a pressurized condition and that the temperature decrease rate was changed as shown in Table 1.

[Measurement of proportion of semi-cured product]

For each composite obtained as described above, the ratio of the semi-cured product to the total pore volume of the boron nitride sintered body was determined. Specifically, a theoretical density $D_0$ (unit: g/cm$^3$) when all the pores of the nitride sintered body were impregnated with the above-described semi-cured product, a bulk density D (unit: g/cm$^3$) obtained from the volume and mass of the nitride sintered body, and a bulk density D (unit: g/cm$^3$) obtained from the volume and mass of each of the above-described composites were used for calculation based on Equation (II) above.

[Measurement of dielectric breakdown voltage]

Each composite sheet obtained as described above was evaluated for dielectric breakdown voltage. Specifically, two sheets of conductive tape were attached to both surfaces of each of the above-described composite sheets to prepare measurement samples. The dielectric breakdown voltage of each of the obtained measurement samples was measured according to JIS C2110-1:2016 with a withstand voltage tester (manufactured by Kikusui Electronics Corp., device name: TOS-8700). The insulation properties were evaluated from the measurement results according to the following criteria. The results are shown in Table 1.

A: The dielectric breakdown voltage is 11 kV or higher.
B: The dielectric breakdown voltage is 8.0 kV or higher and lower than 11 kV
C: The dielectric breakdown voltage is 4.5 kV or higher and lower than 8.0 kV
D: The dielectric breakdown voltage is lower than 4.5 kV

[Evaluation of adhesive strength: evaluation of 90° peelability and adhesiveness]

A layered body obtained by placing each composite sheet obtained as described above between two copper plates, heating and pressurizing the structure under the conditions of 200°C and 5 MPa for 5 minutes, and further heating the structure under the conditions of 200°C and atmospheric pressure for 2 hours was prepared and used as a measurement target. A 90° peeling test was performed according to JIS K 6854-1:1999 "Adhesives-Testing methods for peel adhesion strength", and the peel strength of the composite at 20°C was obtained with a universal tester (manufactured by ANDCORP., trade name: RTG-1310). Measurement was performed under the conditions of a test speed of 50 mm/min, a load cell of 5 kN, and a measurement temperature of room temperature (20°C), and the area of a cohesive failure part was measured. The adhesiveness was evaluated from the measurement results according to the following criteria. The results are shown in Table 1. The cohesive failure part is the area of a part where a composite is broken.

A: The area ratio of the cohesive failure part is 96 area% or more.
B: The area ratio of the cohesive failure part is 95 area% or more and less than 96 area%.
C: The area ratio of the cohesive failure part is 70 area% or more and less than 95 area%.
D: The area ratio of the cohesive failure part is less than 70 area%.

[Table 1]

| | Example 1 | Example 2 | Example 3 | Comparative Example 1 | Comparative Example 2 |
|---|---|---|---|---|---|
| Pressure condition [MPa] in cooling step | 4.0 | 3.9 | 2.4 | Unpressurized | Unpressurized |
| Temperature decrease rate [°C/min] in cooling step | 0.83 | 12 | 0.25 | 0.83 | 16.0 |

(continued)

| | | Example 1 | Example 2 | Example 3 | Comparative Example 1 | Comparative Example 2 |
|---|---|---|---|---|---|---|
| Evaluation | Ratio [volume%] of semi-cured product to total pore volume of boron nitride sintered body | 100 | 99.5 | 99.2 | 94.2 | 94.0 |
| | dielectric breakdown voltage [kV] | 11.6 | 11.1 | 10.5 | 3.3 | 3.1 |
| | Insulation properties | A | A | B | D | D |
| | 90° peel strength [area%] | 96 | 95 | 95 | 94 | 93 |
| | Adhesiveness | A | B | B | B | B |

**Industrial Applicability**

According to the production method for a composite of the present disclosure, it is possible to produce a composite in which the content of a semi-cured product in pores of a nitride sintered body is increased. According to the present disclosure, it is also possible to provide a composite having a very high proportion of a semi-cured product.

**Claims**

**1.** A production method for a composite, comprising:

a cooling step of performing cooling under a pressurized condition in a state where a heated molten material of a thermosetting composition is brought into contact with a resin-impregnated body,
wherein the resin-impregnated body comprises a nitride sintered body having a porous structure and a semi-cured product of the thermosetting composition impregnated into the nitride sintered body.

**2.** The production method according to claim 1,
wherein the pressure in the cooling step is 2.0 MPa or higher.

**3.** The production method according to claim 1 or 2, further comprising:
a preparation step of preparing the resin-impregnated body in which the resin-impregnated body is obtained by semi-curing the thermosetting composition in a state where the nitride sintered body having a porous structure is brought into contact with the heated molten material of the thermosetting composition.

**4.** The production method according to claim 3,
wherein the preparation step includes placing the nitride sintered body and the heated molten material of the thermosetting composition under a pressurized condition in a state where these are brought into contact with each other.

**5.** The production method according to claim 3 or 4,
the pressure in the cooling step is higher than that in the preparation step.

**6.** A composite comprising:

a nitride sintered body having a porous structure; and
a semi-cured product of a thermosetting composition impregnated into the nitride sintered body,
wherein a ratio of the semi-cured product to a total pore volume of the nitride sintered body is 99.0 volume% or higher.

**INTERNATIONAL SEARCH REPORT**

International application No. PCT/JP2021/018244

A. CLASSIFICATION OF SUBJECT MATTER

B29C 39/10(2006.01)i; B32B 18/00(2006.01)i; H01L 23/14(2006.01)i; C04B 38/00(2006.01)i; C04B 41/83(2006.01)i; C04B 35/5835(2006.01)i

FI: C04B41/83 G; C04B38/00 303Z; C04B35/5835; B29C39/10; B32B18/00 C; H01L23/14 R

According to International Patent Classification (IPC) or to both national classification and IPC

B. FIELDS SEARCHED

Minimum documentation searched (classification system followed by classification symbols)

B29C39/10; B32B18/00; H01L23/14; C04B38/00-C04B38/10; C04B41/83; C04B35/00-C04B35/84

Documentation searched other than minimum documentation to the extent that such documents are included in the fields searched

| | |
|---|---|
| Published examined utility model applications of Japan | 1922-1996 |
| Published unexamined utility model applications of Japan | 1971-2021 |
| Registered utility model specifications of Japan | 1996-2021 |
| Published registered utility model applications of Japan | 1994-2021 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | WO 2017/155110 A1 (DENKA COMPANY LIMITED) 14 September 2017 (2017-09-14) claims, paragraphs [0035], [0040], [0044], [0070] | 6<br>1-5 |
| Y | JP 2002-170731 A (YASKAWA ELECTRIC CORPORATION) 14 June 2002 (2002-06-14) paragraphs [0003], [0005] | 1-5 |
| A | Microfilm of the specification and drawings annexed to the request of Japanese Utility Model Application No. 11143/1986 (Laid-open No. 123924/1987) (IBIDEN CO., LTD.) 06 August 1987 (1987-08-06) | 1-6 |
| A | JP 61-275182 A (IBIDEN CO., LTD.) 05 December 1986 (1986-12-05) | 1-6 |

☐ Further documents are listed in the continuation of Box C. ☒ See patent family annex.

* Special categories of cited documents:

"A" document defining the general state of the art which is not considered to be of particular relevance

"E" earlier application or patent but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step when the document is taken alone

"Y" document of particular relevance; the claimed invention cannot be considered to involve an inventive step when the document is combined with one or more other such documents, such combination being obvious to a person skilled in the art

"&" document member of the same patent family

| Date of the actual completion of the international search | Date of mailing of the international search report |
|---|---|
| 22 June 2021 (22.06.2021) | 29 June 2021 (29.06.2021) |

| Name and mailing address of the ISA/ | Authorized officer |
|---|---|
| Japan Patent Office<br>3-4-3, Kasumigaseki, Chiyoda-ku,<br>Tokyo 100-8915, Japan | <br><br>Telephone No. |

Form PCT/ISA/210 (second sheet) (January 2015)

**INTERNATIONAL SEARCH REPORT**
Information on patent family members

International application No.
PCT/JP2021/018244

| Patent Documents referred in the Report | Publication Date | Patent Family | Publication Date |
|---|---|---|---|
| WO 2017/155110 A1 | 14 Sep. 2017 | US 2019/0092695 A1<br>claims, paragraphs [0044], [0049], [0053], [0081]<br>CN 109153801 A | |
| JP 2002-170731 A | 14 Jun. 2002 | (Family: none) | |
| JP 62-123924 U1 | 06 Aug. 1987 | (Family: none) | |
| JP 61-275182 A | 05 Dec. 1986 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2014196496 A